# EUROPÄISCHE PATENTSCHRIFT

(11) **EP 2 829 163 B1**
(45) Veröffentlichungstag und Bekanntmachung des Hinweises auf die Patenterteilung: **09.08.2017**
(21) Anmeldenummer: 13711574.7
(22) Anmeldetag: 19.03.2013
(51) Int. Cl.: H05K 1/11, H05K 3/40, G06K 19/077, H05K 1/09, H05K 1/16, H05K 3/12, H05K 3/00

(54) **SUBSTRAT FÜR EINEN PORTABLEN DATENTRÄGER**
SUBSTRATE FOR A PORTABLE DATA CARRIER
SUBSTRAT POUR UN SUPPORT DE DONNÉES PORTABLE

(30) Priorität: 22.03.2012 DE 102012005831
(43) Veröffentlichungstag der Anmeldung: 28.01.2015
(73) Patentinhaber: Giesecke & Devrient GmbH, 81677 München (DE)
(72) Erfinder: BALDISCHWEILER, Michael, 81825 München (DE); BOHN, Carsten, 81667 München (DE)
(86) Internationale Anmeldenummer: PCT/EP2013/000832
(87) Internationale Veröffentlichungsnummer: WO 2013/139470

(56) Entgegenhaltungen:
- EP-A1- 0 699 020
- WO-A2-2007/069886
- FR-A- 1 575 372
- US-A- 6 132 853
- US-A1- 2009 139 759
- US-A1- 2011 247 865

## Beschreibung

Die vorliegende Erfindung betrifft ein Substrat für einen portablen Datenträger, einen Datenträgerkörper für einen portablen Datenträger sowie einen portablen Datenträger jeweils mit einem solchen Substrat und ein Verfahren zur Herstellung eines Substrats für einen portablen Datenträger.

Portable, meist kartenförmige Datenträger, insbesondere Chipkarten, werden in vielen Bereichen eingesetzt, beispielsweise als Ausweisdokumente, zum Nachweis einer Zugangsberechtigung zu einem Mobilfunknetz oder zur Durchführung von Transaktionen des bargeldlosen Zahlungsverkehrs. Eine Chipkarte weist einen Kartenkörper und einen in den Kartenkörper eingebetteten integrierten Schaltkreis auf.

Eine Kommunikation mit dem integrierten Schaltkreis kann über ein Kontaktfeld der Chipkarte abgewickelt werden, das hierzu von einer Kontaktiereinheit berührend kontaktiert wird. Alternativ oder zusätzlich zur Kommunikation über das Kontaktfeld kann eine kontaktlose Kommunikation vorgesehen sein. Hierzu kann der Kartenkörper eine Antenne aufweisen, die beim Einbau des Chipmoduls mit dem integrierten Schaltkreis elektrisch leitend verbunden wird. Abhängig vom Einsatzgebiet der Chipkarte kann der Kartenkörper außer der Antenne auch andere oder weitere elektrische Komponenten aufweisen, die beim Einbau des Chipmoduls mit dem integrierten Schaltkreis elektrisch leitend verbunden werden.

Die elektrische Komponente, wie zum Beispiel eine Antenne, kann insbesondere mit einem elektrisch leitfähigen Material auf eine Kunststofffolie, welche das Trägermaterial des Substrats bildet, aufgedruckt sein. Das Substrat mit der elektrischen Komponente wird insbesondere auch als Inlay, insbesondere Antennen-Inlay, bezeichnet und bildet eine Schicht des Datenträgerkörpers. Falls die elektrische Komponente auf zwei gegenüberliegenden Oberflächen des Substrats aufgebracht ist, erfolgt eine Durchkontaktierung durch das Substrat hindurch, um die Teile der elektrischen Komponente auf den gegenüberliegenden Seiten elektrisch leitend zu verbinden.

Das Durchkontaktieren kann beispielsweise mechanisch mittels eines Schneide- oder Stanzwerkzeugs erfolgen, mit dem eine Durchbrechung durch das Substrat hindurch erzeugt wird. Die dabei auftretende mechanische Belastung des Substrats kann allerdings die bereits auf dem Substrat vorhandene Schicht aus elektrisch leitfähigem Material beschädigen. Zudem muss das Werkzeug scharf genug sein, um eine Durchkontaktierung sicherzustellen.

Aus der US 2009/139759 A1 ist eine laminierte elektronische Komponente bekannt, die Durchgangslöcher zur Kontaktierung aufweist. Um eine sichere Kontaktierung herzustellen, werden die Kontaktflächen benachbarter Schichten jeweils derart gewählt, dass eine größere Kontaktfläche eine 1,1 bis 2,25-fach kleinere Kontaktfläche kontaktiert.

Aufgabe der vorliegenden Erfindung ist es daher, ein Substrat für einen portablen Datenträger sowie ein entsprechendes Herstellungsverfahren für ein solches Substrat vorzuschlagen, das eine sichere Durchkontaktierung bietet, wobei die Durchkontaktierung herstellbar ist, ohne das Substrat starken mechanischen Belastungen auszusetzen.

Diese Aufgabe wird durch ein Substrat für einen portablen Datenträger, einen Datenträgerkörper für einen portablen Datenträger sowie einen portablen Datenträger jeweils mit einem solchen Substrat und ein Verfahren zur Herstellung eines Substrats für einen portablen Datenträger mit den Merkmalen der unabhängigen Ansprüche gelöst. Vorteilhafte Ausgestaltungen und Weiterbildungen sind in den abhängigen Ansprüchen angegeben.

Ein Substrat für einen portablen Datenträger weist in zumindest einem Durchkontaktierungsbereich des Substrats mindestens eine Durchbrechung auf, durch welche hindurch Teile einer elektrischen Komponente, wie einer Antenne, auf einander gegenüberliegenden Seiten des Substrats elektrisch leitend miteinander verbunden sind. Erfindungsgemäß weist die Durchbrechung eine maximale Weite von maximal 20 µm, vorzugsweise maximal 15 µm, weiter vorzugsweise maximal 10 µm, auf.

Durch das Vorsehen von zumindest einer Durchbrechung mit einer derart beschränkten maximalen Weite kann eine sichere Durchkontaktierung von einer Oberfläche des Substrats zu der gegenüberliegenden Oberfläche des Substrats bereitgestellt werden. Die Weite der Durchbrechung ist groß genug, so dass das elektrisch leitfähige Material, insbesondere Partikel des elektrisch leitfähigen Materials, wie einer Silberleitpaste, durch die Durchbrechung hindurch treten kann und dabei in der Durchbrechung haften bleibt, um die elektrisch leitfähige Verbindung von einer Seite des Substrats zur anderen Seite des Substrats, d.h. die Durchkontaktierung, zu bilden. Insbesondere können dabei auch Kapillarkräfte auftreten, welche das elektrisch leitfähige Material in die Durchbrechung ziehen. Die Beschränkung der maximalen Weite der Durchbrechung bewirkt, dass das elektrisch leitfähige Material nicht durch die Durchbrechung des Substrats hindurchläuft, ohne haften zu bleiben. Dadurch können Verschmutzungen der Maschinen bei der Herstellung reduziert werden.

Unter maximaler Weite wird insbesondere diejenige Abmessung des Querschnitts einer Durchbrechung bzw. ihrer Öffnung im Substrat verstanden, welche dem maximalen Abstand zwischen zwei derart gegenüberliegenden Seiten entspricht, dass eine gewünschte Anzahl von Partikeln eines Materials mit einer bestimmten Partikelgröße nebeneinander durch die Durchbrechung treten kann. Die maximale Weite der Durchbrechung kann insbesondere auch der lichten Weite der Durchbrechung entsprechen. Insbesondere kann die maximale Weite die Breite oder der Durchmesser einer Durchbrechung oder auch die maximale geometrische Abmessung in einer Querrichtung einer Durchbrechung sein. Bei komplexen oder unregelmäßigen Querschnittsgeometrien kann insbesondere auch die kleinste konvexe Fläche, welche den Querschnitt der Durchbrechung enthält (konvexen Hülle) oder die größte konvexe Fläche, welche in dem Querschnitt der Durchbrechung enthalten ist, zur Bestimmung der maximalen Weite herangezogen werden.

Vorteilhafterweise weist das elektrisch leitfähige Material Partikel mit einer bestimmten Partikelgröße auf, wie beispielsweise eine Silberleitpaste mit Silberleitpartikeln im Bereich von ungefähr 3 µm. Unter Partikelgröße kann insbesondere die maximale geometrische Ausdehnung eines Partikels verstanden werden. Die Partikelgröße kann auch über den sogenannten Äquivalentdurchmesser definiert werden. Die maximale Weite der zumindest einen Durchbrechung entspricht vorzugsweise dem zwei- bis fünffachen, besonders bevorzugt maximal dem vierfachen der mittleren Partikelgröße. Die Weite der Durchbrechung liegt somit in einem Bereich, der gerade ein Eindringen oder auch Durchtreten der Partikel in bzw. durch die Durchbrechung erlaubt. Jedoch fließt das elektrisch leitfähige Material aufgrund der Obergrenze der maximalen Weite der Durchbrechung nicht ungehindert durch die Durchbrechung hindurch, sondern haftet in der Durchbrechung an.

Insbesondere ist es vorteilhaft, wenn die zumindest eine Durchbrechung einen ovalen oder länglichen Querschnitt aufweist. Durch Vorsehen eines ovalen Querschnitts der Durchbrechung kann der Haftungseffekt des elektrisch leitfähigen Materials in der Durchbrechung verbessert werden. Im Falle von Durchbrechungen mit länglichem Querschnitt kann das elektrisch leitfähige Material die Stränge des Substratmaterials, die zwischen den Durchbrechungen verbleiben, umschließen, wodurch die Durchkontaktierung weiter verbessert wird, da eine besonders stabile elektrische Verbindung zwischen den beiden gegenüberliegenden Oberflächen des Substrats mittels des elektrisch leitfähigen Materials hergestellt wird. Insbesondere eine Durchbrechung mit ovalem Querschnitt kann des Weiteren einen Quersteg, beispielsweise in der Mitte, also entlang der kurzen Halbachse, aufweisen, was die Haftung des elektrisch leitfähigen Materials in der Durchbrechung weiter verbessert.

In einer bevorzugten Ausgestaltung weist der zumindest eine Durchkontaktierungsbereich des Substrats eine Vielzahl von Durchbrechungen auf. Dadurch kann die Durchkontaktierung im Vergleich zu einem Durchkontaktierungsbereich insbesondere mit nur einer Durchbrechung verbessert werden. Das elektrisch leitfähige Material kann dabei in alle Durchbrechungen in einem Durchkontaktierungsbereich eindringen. Es können beispielsweise zwölf oder mehr Durchbrechungen in einem Durchkontaktierungsbereich vorgesehen sein. Eine Vielzahl von Durchbrechungen in einem Durchkontaktierungsbereich kann auch als Perforation oder Mikroperforation bezeichnet werden. Die Durchkontaktierung kann somit im Wesentlichen über die gesamte Fläche eines Durchkontaktierungsbereichs bereitgestellt werden, was im Vergleich zu einer nur punktförmigen oder schlitzförmigen Durchkontaktierung eine zuverlässigere Durchkontaktierung bietet.

Falls eine Vielzahl von Durchbrechungen in einem Durchkontaktierungsbereich vorgesehen wird, können die Durchbrechungen beispielsweise im Wesentlichen gleichmäßig über den Durchkontaktierungsbereich verteilt sein. Es ist auch möglich, die Durchbrechungen in einem Raster oder Feld mit mehreren Zeilen und/ oder Spalten anzuordnen. Besonders vorteilhaft ist es, die Durchbrechungen in einem Feld anzuordnen, in dem die Zeilen oder Spalten versetzt zueinander angeordnet sind. Derartige Anordnungen verbessern die Durchkontaktierung weiter.

Es ist besonders vorteilhaft, wenn die zumindest eine Durchbrechung des Substrats ausschließlich mit dem elektrisch leitfähigen Material gefüllt ist. Das bedeutet, dass die elektrische Verbindung von einer Oberfläche des Substrats zu der gegenüberliegenden Oberfläche des Substrats ausschließlich über das elektrisch leitfähige Material erfolgt, aus welchem insbesondere die elektrische Komponente gebildet ist. Es ist somit keine zusätzliche Durchkontaktierung aus einem anderen Material erforderlich.

Es ist vorteilhaft, Kontaktbereiche des Substrats, über die ein elektrischer Kontakt zu einem elektronischen Modul eines portablen Datenträgers, beispielweise mittels eines elastischen elektrischen leitfähigen Materials, sogenannter Bumps, hergestellt werden soll, als Durchkontaktierungsbereich mit den beschriebenen Durchbrechungen auszugestalten. Falls der Kontaktbereich des Substrats beispielsweise durch einen Riss unterbrochen ist und somit die elektrische Verbindung zu dem elektronischen Modul beeinträchtigt würde, kann der Riss über die Durchkontaktierung über eine intakte Schicht aus elektrisch leitfähigem Material auf der gegenüberliegenden Seite des Substrats überbrückt werden. Mit anderen Worten, um die Zuverlässigkeit des elektrischen Kontakts zwischen der elektrischen Komponente und einem elektronischen Modul zu verbessern, kann eine Kontaktfläche für das elektronische Modul, welche sich beispielsweise auf der Vorderseite des Substrats befindet, auf der Rückseite des Substrats redundant ausgeführt werden und über Durchkontaktierungen mit dieser elektrisch leitend verbunden werden.

Das Substrat mit der elektrischen Komponente kann eine Schicht eines Datenträgerkörpers, ein sogenanntes Inlay, bilden. Der Datenträgerkörper kann einen Teil eines portablen Datenträgers, wie einer Chipkarte, bilden. Insbesondere kann ein integrierter Schaltkreis mit der elektronischen Komponente auf dem Substrat elektrisch verbunden sein.

Zur Herstellung des Substrats wird eine Kunststofffolie bereitgestellt, in die in zumindest einen Durchkontaktierungsbereich mittels eines Lasers zumindest eine derartige Durchbrechung eingebracht wird. Das elektrisch leitfähige Material wird bei der Herstellung des Substrats auf zwei gegenüberliegende Oberflächen der Kunststofffolie im Bereich der Durchbrechung derart aufgebracht, dass durch die Durchbrechung hindurch eine elektrisch leitfähige Verbindung zwischen den einander gegenüberliegenden Oberflächen der Kunststofffolie gebildet wird. Da die Durchbrechungen mittels eines Lasers gebildet werden, können mechanische Belastungen auf das Substrat bzw. die Kunststofffolie vermieden werden. Somit kann die Folienstärke unabhängig von der Durchkontaktierung gewählt werden. Es können insbesondere dünne Kunststofffolien verwendet werden, welche den mechanischen Belastungen durch ein Schneide- oder Stanzwerkzeug nicht standhalten würden. Insbesondere, falls vor dem Bilden der Durchbrechung bereits elektrisch leitfähiges Material auf die Kunststofffolie aufgetragen wurde, unterliegt dieses keiner mechanischen Belastung, wodurch es zu Rissbildungen kommen könnte, insbesondere bei sehr dünnen Folien, welche sich bei Einwirkung eines Schneide- oder Stanzwerkzeugs relativ stark verformen würden.

Vorteilhaft ist es, wenn die zumindest eine Durchbrechung mittels des Lasers nach dem Aufbringen des elektrisch leitfähigen Materials auf eine der einander gegenüberliegenden Oberflächen der Kunststofffolie gebildet wird. Somit ist eine Seite der Durchbrechung bereits durch das elektrisch leitfähige Material verschlossen, so dass ein ungewolltes Austreten des elektrisch leitfähigen Materials ausgeschlossen werden kann. Insbesondere werden die Parameter des Lasers, wie Energie und Frequenz dabei so eingestellt, dass die Kunststofffolie zur Bildung der Durchbrechung durchbrochen wird, das bereits auf der gegenüberliegenden Oberfläche der Folie aufgebrachte elektrisch leitfähige Material jedoch nicht zerstört wird. Die Durchbrechung kann auch vor dem Aufbringen des elektrisch leitfähigen Materials auf die Kunststofffolie gebildet werden.

Weiter vorteilhaft ist es, wenn das elektrisch leitfähige Material zur Bildung einer elektrischen Komponente derart auf die Kunststofffolie aufgebracht wird, dass das elektrisch leitfähige Material während des Aufbringens auf die Kunststofffolie in die Durchbrechung der Kunststofffolie eindringt. Somit können das Bilden der elektrischen Komponente und die Durchkontaktierung in einem Schritt erfolgen. Vorzugsweise wird das elektrisch leitfähige Material im Siebdruckverfahren auf die Kunststofffolie aufgebracht.

Die Erfindung wird im Folgenden mit Bezug auf die beiliegenden schematischen Zeichnungen beispielhaft beschrieben. Darin zeigen:
Fig. 1 einen portablen Datenträger in Draufsicht mit angedeuteten Antennenwindungen und Durchkontaktierungsbereichen,
Fig. 2 eine Oberfläche eines Substrats in Draufsicht,
Fig. 3 eine der in Fig. 2 dargestellten Oberfläche gegenüberliegende Oberfläche des Substrats in Draufsicht,
Fig. 4 eine Detailansicht eines Durchkontaktierungsbereich mit ovalen Durchbrechungen,
Fig. 5 ein Ausführungsbeispiel einer ovalen Durchbrechung mit Quersteg und
Fig. 6 eine Detailansicht eines Durchkontaktierungsbereich mit länglichen Durchbrechungen.

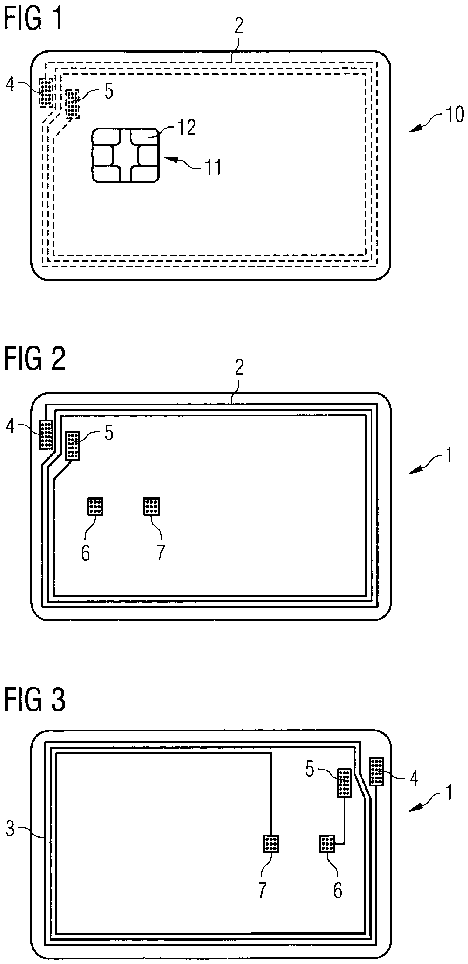

In Fig. 1 ist ein portabler Datenträger 10 in Form einer Chipkarte dargestellt. Der Datenträger 10 weist ein Chipmodul 11 auf, welches einen integrierten Schaltkreis und Kontaktflächen 12 zur kontaktbehafteten Kommunikation mit einem entsprechenden Lesegerät enthält. Der portable Datenträger 10 weist zudem eine Kontaktlosschnittstelle in Form einer Antenne 2, 3 auf, deren Verlauf in Fig. 1 angedeutet ist. Die Antenne 2, 3 ist mit dem integrierten Schaltkreis verbunden.

In Fig. 2 ist eine der Oberflächen, beispielsweise die Oberseite, eines Substrats 1 dargestellt, welches als sogenanntes Inlay in einen portablen Datenträger 10 beispielsweise mittels Laminieren als eine Schicht des Datenträgerkörpers integriert werden kann. Fig. 2 zeigt einen ersten Teil 2 der Antenne, welcher auf der Oberseite des Substrats 1 angeordnet ist. Die Verbindung der Antenne mit dem integrierten Schaltkreis des Datenträgers kann über sogenannte Bumps aus einem elastischen, elektrisch leitfähigen Material erfolgen, welche auf entsprechende Auflageflächen auf dem Substrat 1, hier in Form von Durchkontaktierungsbereichen 6, 7 aufgebracht werden. Die Durchkontaktierungsbereiche 6, 7 können beispielweise eine Größe von ungefähr 3 x 3 mm aufweisen. Die Enden des ersten Teils 2 der Antenne auf der Oberseite des Substrats 1 münden in Durchkontaktierungsbereichen 4, 5, über welche eine elektrische Verbindung zu einem zweiten Teil 3 der Antenne auf der Rückseite des Substrats 1 besteht.

Die Rückseite des Substrats 1 ist in Fig. 3 dargestellt. In den Durchkontaktierungsbereichen 4, 5 ist der zweite Teil 3 der Antenne mit dem ersten Teil 2 der Antenne elektrisch verbunden. Der zweite Teil 3 der Antenne auf der Rückseite des Substrats endet in dem Durchkontaktierungsbereich 7, in dem eine elektrische Verbindung zu der Vorderseite des Substrats 1 besteht. Auf der Rückseite des Substrats 1 ist der Durchkontaktierungsbereich 5 mit dem Durchkontaktierungsbereich 6 verbunden, so dass die Antenne elektrisch geschlossen ist. Andere Konfigurationen der Antenne sind selbstverständlich möglich. Es ist vorteilhaft, die Auflageflächen für die Kontakte, d.h. insbesondere die sogenannten Bumps, zu dem Chipmodul 11 als Durchkontaktierungsbereiche 6, 7 auszugestalten. Insbesondere sind in diesem Ausführungsbeispiel die Durchkontaktierungsbereiche 5, 6 statt direkt auf der Vorderseite des Substrats 1 auf der Rückseite des Substrats 1 miteinander elektrisch verbunden. Der elektrische Kontakt der Antenne 2, 3 zu dem Chipmodul 11 kann dadurch zuverlässiger gestaltet werden, da beispielsweise in Riss auf der Vorderseite eines der Durchkontaktierungsbereiche 6, 7 über die Durchkontaktierung auf die Rückseite des entsprechenden Durchkontaktierungsbereichs 6, 7 überbrückt werden kann. Insbesondere ist dies möglich, wenn der entsprechende Durchkontaktierungsbereich 6, 7 eine Vielzahl von Durchbrechungen aufweist, welche über den Durchkontaktierungsbereich 6, 7 verteilt sind.

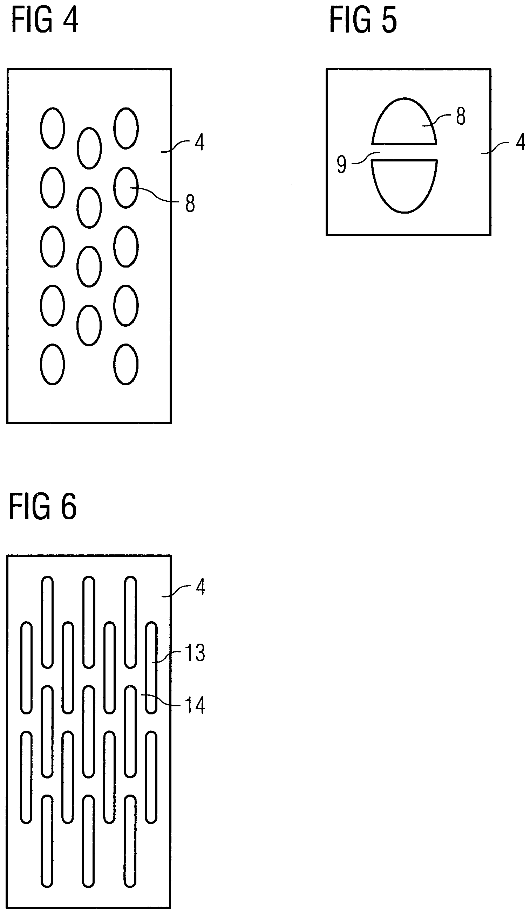

Wie in den Fig. 2 und 3 angedeutet, weisen die Durchkontaktierungsbereiche 4, 5, 6, 7 jeweils eine Vielzahl von Durchbrechungen auf. Dies ist beispielhaft anhand des Durchkontaktierungsbereichs 4 in Fig. 4 im Detail dargestellt. Der Durchkontaktierungsbereich 4 weist mehrere ovale Durchbrechungen 8 auf, welche in einem Feld mit drei Spalten angeordnet sind. Die Spalten sind zueinander versetzt. Jede der Durchbrechungen weist eine maximale Weite von maximal 20 µm auf, insbesondere eine maximale Weite, die kleiner oder gleich dem vierfachen der mittleren Partikelgröße des verwendeten elektrisch leitfähigen Materials, wie einer Silberleitpaste mit Partikel mit einer Partikelgröße von 3 µm, ist.

In Fig. 5 ist eine ovale Durchbrechung 8, welche einen Quersteg 9 in der Mitte aufweist, vergrößert dargestellt. Ein weiteres Ausführungsbeispiel von Durchbrechungen ist in Fig. 6 dargestellt. Die Durchbrechungen 13 weisen einen länglichen Querschnitt auf und sind durch Stege 14 voneinander getrennt. Alle gezeigten Durchbrechungen 8,13 sind mittels eines Lasers herstellbar. Die Partikel eines elektrisch leitfähigen Materials können in die durch die Durchbrechungen 8,13 gebildete Perforation des Substrats 1 eindringen und haften bleiben, so dass eine zuverlässige Durchkontaktierung erreicht wird, ohne dass das elektrische leitfähige Material beim Aufbringen beispielsweise mittels Siebdruck auf der gegenüberliegenden Seite des Substrats 1 austritt. Durch Verwendung eines Lasers statt mechanischer Werkzeuge wird eine mechanische Belastung auf das Substrat während der Herstellung vermieden.

## Patentansprüche

1. Substrat (1) für einen portablen Datenträger (10), umfassend eine elektrische Komponente (2, 3), die zwei auf einander gegenüberliegenden Oberflächen des Substrats (1) aufgebrachte Teile aufweist, welche ein elektrisch leitfähiges Material umfassen und in zumindest einem Durchkontaktierungsbereich (4, 5, 6, 7) des Substrats (1) durch mindestens eine mittels eines Lasers gebildeten Durchbrechung (8,13) des Substrats (1) hindurch elektrisch leitend miteinander verbunden sind, **dadurch gekennzeichnet, dass** das elektrisch leitfähige Material Partikel umfasst, wobei die maximale Weite der Durchbrechung (8,13) dem zwei- bis fünffachen, vorzugsweise maximal dem vierfachen, der mittleren Partikelgröße entspricht und dass die Durchbrechung einen Quersteg (9) aufweist, und wobei die Durchbrechung (8,13) eine maximale Weite von 20 µm aufweist.

2. Substrat nach Anspruch 1, **dadurch gekennzeichnet, dass** die maximale Weite der Durchbrechung (8,13) maximal 15 µm, vorzugsweise maximal 10 µm, ist.

3. Substrat nach einem der Ansprüche 1 bis 2, **dadurch gekennzeichnet,**
**dass** die Durchbrechung (8,13) einen ovalen oder länglichen Querschnitt aufweist.

4. Substrat nach einem der Ansprüche 1 bis 3, **dadurch gekennzeichnet,**
**dass** der zumindest eine Durchkontaktierungsbereich (4, 5, 6, 7) eine Vielzahl der Durchbrechungen (8,13) aufweist.

5. Substrat nach Anspruch 4, **dadurch gekennzeichnet, dass** die Vielzahl
von Durchbrechungen (8,13) in dem zumindest einen Durchkontaktierungsbereich (4, 5, 6, 7) in einem Feld mit mehreren Zeilen und/ oder mehreren Spalten angeordnet sind.

6. Substrat nach Anspruch 5, **dadurch gekennzeichnet, dass** die Zeilen
oder Spalten von Durchbrechungen (8,13) in dem Feld versetzt zueinander angeordnet sind.

7. Substrat nach einem der Ansprüche 1 bis 6, **dadurch gekennzeichnet,**
**dass** die mindestens eine Durchbrechung (8,13) ausschließlich mit dem elektrisch leitfähigen Material gefüllt ist.

8. Datenträgerkörper für einen portablen Datenträger (10), umfassend ein Substrat (1) nach einem der Ansprüche 1 bis 7, wobei das Substrat (1) eine Schicht des Datenträgerkörpers bildet.

9. Portabler Datenträger (10), umfassend ein Substrat (1) nach einem der Ansprüche 1 bis 7 oder einen Datenträgerkörper nach Anspruch 8.

10. Verfahren zur Herstellung eines Substrats (1) für einen portablen Datenträger (10), umfassend die Schritte:
- Bereitstellen einer Kunststofffolie,
- Bilden von zumindest einer Durchbrechung (8,13) mit einer maximalen Weite von 20 µm in zumindest einem Durchkontaktierungsbereich (4, 5, 6, 7) der Kunststofffolie durch die Kunststofffolie hindurch mittels eines Lasers, wobei die Durchbrechung (8,13) einen Quersteg (9) aufweist, und
- Aufbringen eines elektrisch leitfähigen Materials auf zwei einander gegenüberliegende Oberflächen der Kunststofffolie im Bereich der Durchbrechung (8,13) derart, dass durch die Durchbrechung (8,13) hindurch eine elektrisch leitfähige Verbindung zwischen den einander gegenüberliegenden Oberflächen der Kunststofffolie gebildet wird, wobei das elektrisch leitfähige Material Partikel umfasst und die maximale Weite der Durchbrechung (8,13) dem zwei- bis fünffachen, vorzugsweise maximal dem vierfachen, der mittleren Partikelgröße entspricht.

11. Verfahren nach Anspruch 10, **dadurch gekennzeichnet, dass**
die Durchbrechung (8,13) mittels des Lasers nach dem Aufbringen des elektrisch leitfähigen Materials auf eine der einander gegenüberliegenden Oberflächen der Kunststofffolie gebildet wird.

12. Verfahren nach einem der Ansprüche 10 oder 11, **dadurch**
**gekennzeichnet, dass** das elektrisch leitfähige Material zur Bildung einer elektrischen Komponente (2, 3) derart auf die Kunststofffolie aufgebracht wird, dass das elektrisch leitfähige Material während des Aufbringens auf die Kunststofffolie in die Durchbrechung (8,13) der Kunststofffolie ein-.

13. Verfahren nach einem der Ansprüche 10 bis 12, **dadurch gekennzeichnet, dass** das elektrisch leitfähige Material im Siebdruckverfahren auf die Kunststofffolie aufgebracht wird.

## Claims

1. A substrate (1) for a portable data carrier (10) comprising an electrical component (2, 3) having two parts applied to two mutually opposite surfaces of the substrate (1), said parts comprising an electroconductive material and being electroconductively interconnected in at least one feedthrough region (4, 5, 6, 7) of the substrate (1) by at least one aperture (8, 13) of the substrate (1) formed by a laser, **characterized in that** the electroconductive material comprises particles, wherein the maximum width of the aperture (8, 13) corresponds to the two- to five-fold, preferably maximally the four-fold, of the average particle size and that the aperture has a transverse web (9), and wherein the aperture (8, 13) has a maximal width of 20 µm.

2. The substrate according to claim 1, **characterized in that** the maximal width of the aperture (8, 13) is maximally 15 µm, preferably maximally 10 µm.

3. The substrate according to any of the claims 1 to 2, **characterized in that** the aperture (8, 13) has an oval or elongate cross section.

4. The substrate according to any of the claims 1 to 3, **characterized in that** the at least one feedthrough region (4, 5, 6, 7) has a multiplicity of apertures (8, 13).

5. The substrate according to claim 4, **characterized in that** the multiplicity of apertures (8, 13) in the at least one feedthrough region (4, 5, 6, 7) are arranged in a field with a plurality of rows and/or a plurality of columns.

6. The substrate according to claim 5, **characterized in that** the rows or columns of apertures (8, 13) in the field are arranged offset from one another.

7. The substrate according to any of the claims 1 to 6, **characterized in that** the at least one aperture (8, 13) is filled exclusively with the electroconductive material.

8. A data carrier body for a portable data carrier (10) comprising a substrate (1) according to any of the claims 1 to 7, wherein the substrate (1) forms a layer of the data carrier body.

9. A portable data carrier (10) comprising a substrate (1) according to any of the claims 1 to 7 or a data carrier body according to claim 8.

10. A method for manufacturing a substrate (1) for a portable data carrier (10), comprising the steps of:
making available a plastic foil,
forming at least one aperture (8, 13) with a maximal width of 20 µm in at least one feedthrough region (4, 5, 6, 7) of the plastic foil through the plastic foil by means of a laser, wherein the aperture (8, 13) has a transverse web (9), and
applying an electroconductive material to two mutually opposite surfaces of the plastic foil in the region of the aperture (8, 13), such that through the aperture (8, 13) there is formed an electroconductive connection between the mutually opposite surfaces of the plastic foil, wherein the electroconductive material comprises particles and the maximal width of the aperture (8, 13) corresponds to the two- to five-fold, preferably maximally the four-fold, of the average particle size.

11. The method according to claim 10, **characterized in that** the aperture (8, 13) is formed by means of the laser after applying the electroconductive material to one of the mutually opposite surfaces of the plastic foil.

12. The method according to any of the claims 10 or 11, **characterized in that** the electroconductive material for forming an electrical component (2, 3) is so applied to the plastic foil that the electroconductive material penetrates into the aperture (8, 13) of the plastic foil during application to the plastic foil.

13. The method according to any of the claims 10 to 12, **characterized in that** the electroconductive material is applied to the plastic foil by screen printing.

## Revendications

1. Substrat (1) destiné à un support de données (10) portable, comprenant un composant électrique (2, 3) comportant deux parties appliquées sur des surfaces du substrat (1) qui se font face, qui comprennent un matériau électroconducteur et qui, dans au moins une zone de connexion transversale (4, 5, 6, 7) du substrat (1), sont, au moins à travers un transpercement (8, 13) du substrat (1) généré au moyen d'un laser, connectées entre elles de manière électroconductrice, **caractérisé en ce que** le matériau électroconducteur comprend des particules, cependant que la largeur maximale du transpercement (8, 13) correspond à entre deux et cinq fois, de préférence au maximum à quatre fois la taille moyenne de particule, et **en ce que** le transpercement comporte une traverse (9), et cependant que le transpercement (8, 13) présente une largeur maximale de 20 µm.

2. Substrat selon la revendication 1, **caractérisé en ce que** la largeur maximale du transpercement (8, 13) est d'au maximum 15 µm, de préférence d'au maximum 10 µm

3. Substrat selon une des revendications de 1 à 2, **caractérisé en ce que** le transpercement (8, 13) présente une section ovale ou allongée.

4. Substrat selon une des revendications de 1 à 3, **caractérisé en ce que** la au moins une zone de connexion transversale (4, 5, 6, 7) comporte une pluralité des transpercements (8, 13).

5. Substrat selon la revendication 4, **caractérisé en ce que** la pluralité de transpercements (8, 13) dans la au moins une zone de connexion transversale (4, 5, 6, 7) sont agencés dans un champ à plusieurs rangées et/ou à plusieurs colonnes.

6. Substrat selon la revendication 5, **caractérisé en ce que** les rangées ou colonnes de transpercements (8, 13) sont agencées en quinconce les unes par rapport aux autres dans le champ.

7. Substrat selon une des revendications de 1 à 6, **caractérisé en ce que** le au moins un transpercement (8, 13) est exclusivement rempli avec le matériau électroconducteur.

8. Corps de support de données destiné à un support de données (10) portable, comprenant un substrat (1) selon une des revendications de 1 à 7, le substrat (1) constituant une couche du corps de support de données.

9. Support de données (10) portable, comprenant un substrat (1) selon une des revendications de 1 à 7 ou un corps de support de données selon la revendication 8.

10. Procédé de fabrication d'un substrat (1) destiné à un support de données (10) portable, comprenant les étapes :
- mise à disposition d'un film en matière plastique,
- génération d'au moins un transpercement (8, 13) d'une largeur maximale de 20 µm dans au moins une zone de connexion transversale (4, 5, 6, 7) du film en matière plastique à travers le film en matière plastique au moyen d'un laser, le transpercement (8, 13) comportant une traverse (9), et
- application d'un matériau électroconducteur sur deux surfaces se faisant face du film en matière plastique , dans la zone du transpercement (8, 13), de telle façon que, à travers le transpercement (8, 13), une connexion électroconductrice entre les surfaces se faisant face du film en matière plastique est générée, le matériau électroconducteur comprenant des particules, et la largeur maximale du transpercement (8, 13) correspondant à entre deux et cinq fois, de préférence au maximum à quatre fois la taille moyenne de particule.

11. Procédé selon la revendication 10, **caractérisé en ce que** le transpercement (8, 13) est généré au moyen du laser après l'application du matériau électroconducteur sur une des surfaces se faisant face du film en matière plastique.

12. Procédé selon une des revendications 10 ou 11, **caractérisé en ce que** le matériau électroconducteur destiné à la génération d'un composant électrique (2, 3) est appliqué de telle façon sur le film en matière plastique que le matériau électroconducteur est introduit dans le transpercement (8, 13) du film en matière plastique pendant l'application sur le film en matière plastique.

13. Procédé selon une des revendications 10 ou 12, **caractérisé en ce que** le matériau électroconducteur est appliqué par procédé de sérigraphie sur le film en matière plastique.
